# EUROPEAN PATENT APPLICATION

(11) **EP 4 826 544 A1**
(43) Date of publication of application: **21.10.2026**
(21) Application number: 24903239.2
(22) Date of filing: 21.08.2024
(51) Int. Cl.: G06F 11/22, G01R 31/28, H10D 84/03, H10D 84/00

(54) **REUSE DETERMINATION DEVICE FOR SEMICONDUCTOR INTEGRATED CIRCUIT, REUSE DETERMINATION SYSTEM, AND REUSE DETERMINATION METHOD**

(30) Priority: 12.12.2023 JP 2023209509
(71) Applicant: Hitachi, Ltd., Tokyo 100-8280 (JP)
(72) Inventor: NAGASHIMA Tomoharu, Tokyo 100-8280 (JP); NISHIMOTO Takuma, Tokyo 100-8280 (JP)
(74) Representative: Mewburn Ellis LLP
(86) International application number: PCT/JP2024/029618
(87) International publication number: WO 2025/126576

(57) **Abstract**

A normal state and a failure state of a semiconductor integrated circuit are mapped onto a graph, using monitor statistics calculation data, a reuse boundary for separating a region on the graph into a normal data group region and a failure data group region is calculated, and reusability of the semiconductor integrated circuit is determined based on the reuse boundary.

## Description

### TECHNICAL FIELD

The present invention relates to a reuse determination device, a reuse determination system, and a reuse determination method for a semiconductor integrated circuit.

### BACKGROUND ART

As the momentum for reducing environmental impact grows, there is an increasing demand for a technique to reuse semiconductor integrated circuits used inside electronic devices rather than disposing of the semiconductor integrated circuits. As the technique, there is a technique that estimates the degradation of a semiconductor integrated circuit during use. With this technique, it is possible to detect degradation and to efficiently replace the semiconductor integrated circuit.

For example, in Patent Document 1, a means for determining a maximum operating frequency is incorporated into a target semiconductor integrated circuit, the maximum operating frequency is monitored at any timing during use, and the amount of degradation is calculated based on the maximum operating frequency.

### CITATION LIST

### PATENT DOCUMENT

Patent Document 1: International Publication No. WO2011/115038

### SUMMARY OF THE INVENTION

### PROBLEMS TO BE SOLVED BY THE INVENTION

However, in the technique disclosed in Patent Document 1, it is necessary to provide a monitoring circuit for calculating the maximum operating frequency in the target semiconductor integrated circuit. Therefore, the technique lacks versatility, and it is not possible to diagnose the degradation of the semiconductor integrated circuits available in the market.

Furthermore, the degradation of the semiconductor integrated circuit can occur due to a combination of factors, such as hot carrier injection (HCI), bias temperature instability (BTI), and time dependent dielectric breakdown (TDDB), and some degradation is recoverable.

For this reason, simply calculating the amount of degradation makes it difficult to determine the reusability of the target semiconductor integrated circuit, and an inspection equivalent to a shipping inspection is required during reuse determination. The requirement for these inspections leads to increased man-hours and costs, which may act as an obstacle to enhancing the reusability of the semiconductor integrated circuit.

An object of the present invention is to easily determine reusability of a semiconductor integrated circuit.

### SOLUTIONS TO PROBLEMS

According to an aspect of the present invention, there is provided a reuse determination device for a semiconductor integrated circuit that includes a reuse determination unit determining reusability of the semiconductor integrated circuit. A processor causes the reuse determination unit to: determine a state of the semiconductor integrated circuit using monitoring data of the semiconductor integrated circuit; recycle or dispose of the semiconductor integrated circuit when the state of the semiconductor integrated circuit is determined to be a failure; calculate a statistical value of the monitoring data and acquire monitoring statistics calculation data when the state of the semiconductor integrated circuit is determined to be normal; map the normal state and the failure state of the semiconductor integrated circuit onto a graph, using the monitoring statistics calculation data; calculate a reuse boundary for separating a region on the graph into a normal data group region indicating the normal state and a failure data group region indicating the failure state; and determine the reusability of the semiconductor integrated circuit based on the reuse boundary.

### EFFECTS OF THE INVENTION

According to an aspect of the present invention, it is possible to easily determine the reusability of a semiconductor integrated circuit.

### BRIEF DESCRIPTION OF THE DRAWINGS

Fig. 1 is a schematic diagram showing an example of a system configuration of a reuse determination system.
Fig. 2 is a schematic diagram showing an example of a hardware configuration of the reuse determination system according to Embodiment 1.
Fig. 3 is a schematic diagram showing an example of a configuration of an electronic device.
Fig. 4A is a schematic view showing an example of monitoring data.
Fig. 4B is a schematic view showing an example of the monitoring data.
Fig. 5A is a schematic view showing an example of rated data.
Fig. 5B is a schematic view showing an example of the rated data.
Fig. 6A is a schematic view showing an example of classification data and a reuse boundary according to Embodiment 1.
Fig. 6B is a schematic view showing an example of the classification data and the reuse boundary according to Embodiment 1.
Fig. 7 is a flowchart showing an example of a process of determining reusability in Embodiment 1.
Fig. 8 is a flowchart showing an example of a process when the classification data and the reuse boundary are calculated in Embodiment 1.
Fig. 9 is a schematic diagram showing an example of a hardware configuration of a reuse determination system according to Embodiment 2.
Fig. 10 is a schematic view showing an example of classification data and a reuse boundary according to Embodiment 2.
Fig. 11 is a flowchart showing an example of a process when reusability is determined in Embodiment 2.
Fig. 12 is a flowchart showing an example of a process when the classification data and the reuse boundary are calculated in Embodiment 2.

### MODE FOR CARRYING OUT THE INVENTION

Hereinafter, embodiments will be described using the drawings. In addition, in all the drawings for describing the embodiments, the same members are generally denoted by the same reference numerals, and a redundant description thereof will be omitted as appropriate.

Further, in the following embodiments, it goes without saying that constituent elements (including element steps and the like) are not necessarily essential, except when specifically stated otherwise or when considered clearly essential in principle.

Furthermore, it goes without saying that expressions, such as "consisting of A", "being composed of A", "having A", and "including A", do not exclude elements other than A, unless specifically stated to the effect that only those elements are present.

Similarly, in the following embodiments, when the shapes, positional relationships, and the like of constituent elements are mentioned, they include shapes that are substantially approximate or similar to the above-mentioned shapes and the like, except when specifically stated otherwise or considered clearly not to be the case in principle.

### [Embodiment 1]

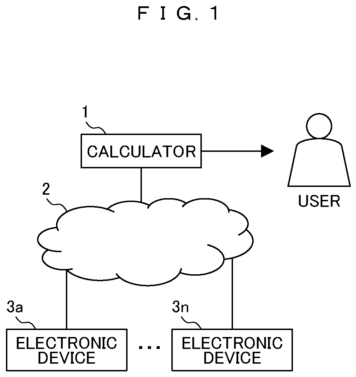

Fig. 1 is a schematic diagram showing an example of a system configuration of a reuse determination system. The reuse determination system is a system that determines reusability of a semiconductor integrated circuit and includes a computer 1 and electronic devices 3a to 3n.

The computer 1 is a computer that determines reusability and presents the results of the reusability determination to a user through a graphical user interface (GUI) or like. The electronic devices 3a to 3n are intended to be devices, such as industrial devices, IT devices, and medical devices, and edge devices and are devices including semiconductor integrated circuits to be subjected to the reusability determination. The computer 1 and the electronic devices 3a to 3n are connected to each other via a network (communication line) 2 such as the Internet or a local area network (LAN).

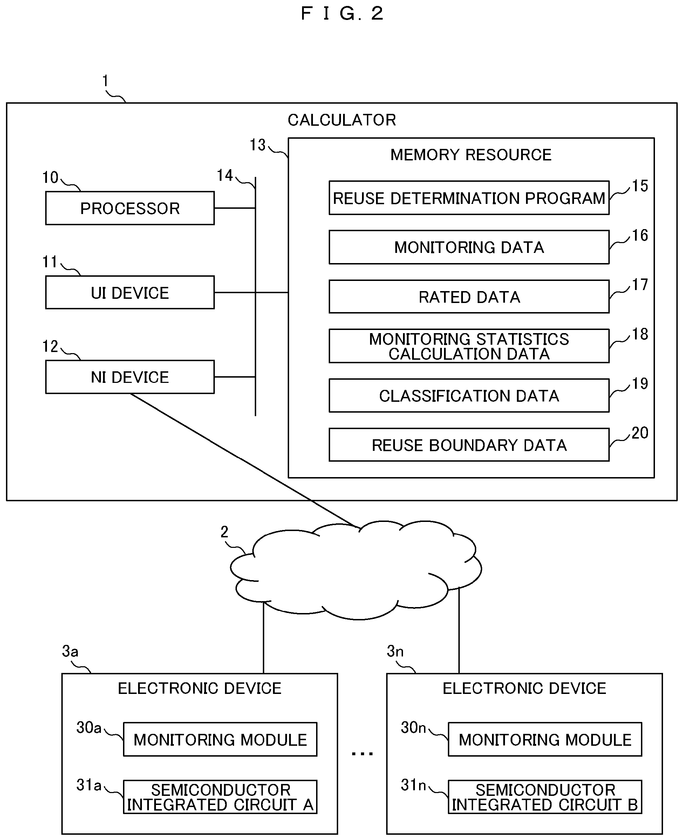

Fig. 2 is a schematic diagram showing an example of a hardware configuration of the reuse determination system according to Embodiment 1.

The electronic devices 3a to 3n are systems having monitoring modules 30a to 30n and semiconductor integrated circuits 31a to 31n.

The monitoring modules 30a to 30n are modules that include sensors for measuring the voltage and temperature of the semiconductor integrated circuits 31a to 31n and processors, such as central processing units (CPUs), for controlling the sensors. In addition, monitoring circuits, such as voltmeters and thermometers, may notify the computer 1, using the internal functions of the semiconductor integrated circuits 31a to 31n. The monitoring modules 30a to 30n have a configuration common to the semiconductor integrated circuits 31a to 31n.

The semiconductor integrated circuits 31a to 31n are processors, such as central processing units (CPUs) or field programmable gate arrays (FPGAs), for implementing the functions of the electronic devices 3a to 3n and are components to be subjected to the reusability determination.

The processor 10 reads a processing program stored in a memory resource 13 and executes processes corresponding to the processing program such that the computer 1 performs the generation, transmission, and reception of data and various other processes.

Further, the computer 1 may be, for example, a computer, such as a personal computer, a tablet terminal (computer), a smartphone, a server computer, a blade server, or a cloud server, and may be a system including at least one of these computers. In other words, the computer 1 also includes a system that includes, for example, a cloud server and a display computer (for example, a tablet terminal or a smartphone). Furthermore, a controller that controls or manages any device including the processor 10 and the memory resource 13 is also an example of the computer 1.

Specifically, as shown in Fig. 2, the computer 1 has one or more processors 10, one or more user interface (UI) devices 11, one or more network interface (NI) devices 12, and one or more memory resources 13. In addition, the computer 1 may include components other than the above. Further, the processor 10, the UI device 11, the NI device 12, and the memory resource 13 are connected to each other via a bus 14.

The processor 10 is an arithmetic device that reads a reuse determination program 15 stored in the memory resource 13 and executes each process of a reuse determination method. In addition, examples of the processor 10 include a microprocessor, a CPU, a graphics processing unit (GPU), a field programmable gate array (FPGA), a quantum processor, and other semiconductor devices capable of performing calculations.

The UI device 11 is an input device that inputs instructions from the user (or an operator) to the computer 1 and an output device that outputs information and the like generated by the computer 1. Examples of the input device include pointing devices, such as keyboards, touch panels, and mouses, and voice input devices, such as microphones.

In addition, examples of the output device include displays, printers, and voice synthesis devices. Further, it is assumed that information is input and output between the computer 1 and the user via the UI device 11 unless otherwise specified below. Furthermore, the UI device 11 may include only the input device or only the output device.

The NI device 12 is a communication device that performs information communication with external devices. The NI device 12 performs information communication with external devices, such as the electronic devices 3a to 3n, via the network 2. Further, it is assumed that the information communication between the computer 1 (or the processor 10) and the external devices is executed via the NI device 12 unless otherwise specified below.

The memory resource 13 is, for example, a non-volatile memory and/or a volatile memory. Examples of the volatile memory include a random access memory (RAM) and a read only memory (ROM). Examples of the non-volatile memory may include rewritable storage media, such as a flash memory, a hard disk, and a solid state drive (SSD), or may include a universal serial bus (USB) memory, a memory card, and a hard disk.

Further, RAMs, such as a magnetoresistive RAM (MRAM), a phase change RAM (PRAM), and a resistive RAM (ReRAM), may also be regarded as the non-volatile memories. Furthermore, the processor 10 may also provide a service to distribute the reuse determination program 14 stored in the memory resource 13 to other computers.

The memory resource 13 stores the reuse determination program 15, monitoring data 16, rated data 17, monitoring statistical value data 18, classification data 19, and reuse boundary data 20.

The reuse determination program 15 is a program for the computer 1 to execute the reuse determination method and functions as a reuse determination unit.

The monitoring data 16 is information obtained from the monitoring modules 30a to 30n of the electronic devices 3a to 3n via the NI device 12 and stores voltages, temperatures, operating states (normality or failure), and the like related to the semiconductor integrated circuits 31a to 31n of the electronic devices 3a to 3n.

The rated data 17 is rated information obtained from data sheets and the like of the semiconductor integrated circuits 31a to 31n to be subjected to the reuse determination and is stored in the memory resource 13 in advance by the user. Information, such as a maximum voltage, minimum and maximum junction temperatures, and electro-static discharge (ESD), is primarily stored.

The monitoring statistics calculation data 18 is information of statistical values, such as a maximum value, an average value, and a standard deviation, during any period which are calculated from the monitoring data 16 and is stored in the memory resource 13 in advance by the user.

The classification data 19 are a plurality of graphs in which the operating state (a binary value indicating normality or failure) is plotted and the statistical values of the monitoring data 16 are used as axes.

The reuse boundary data 20 is information in which a plane separating a normal data group from a failure data group in each graph is defined as the reuse boundary. The reuse boundary can be calculated to determine the reusability from the statistical information of the monitoring data 16.

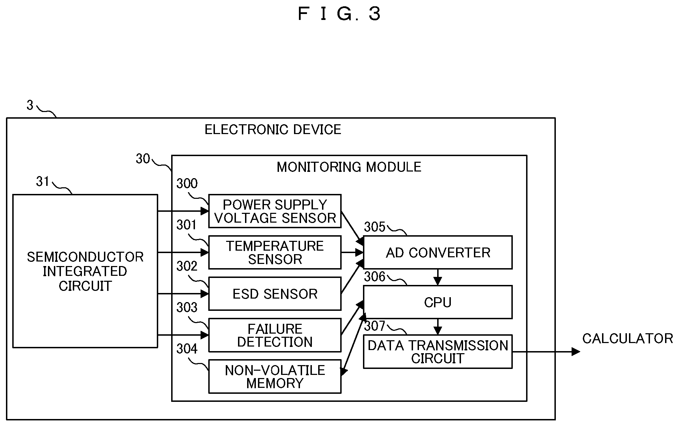

Fig. 3 shows an example of a configuration of the electronic device 3.

Fig. 3 shows an example in which a power supply voltage sensor 300, a temperature sensor 301, and an ESD sensor 302 are provided in order to monitor a power supply voltage, temperature, and ESD which are primarily indicated as device rating values on a data sheet. Analog information of each sensor is acquired as digital values by an AD converter 305 and is transmitted as the monitoring data 16 to the computer 1 via a CPU 306 and a data transmission circuit 307.

At this time, the CPU 306 includes a thinning process of transmitting data at any timing (for example, daily) and a process of storing pre-transmission data in the non-volatile memory 304 and transmitting the data at any timing. In addition, a failure detection circuit 303 that detects a failure in the semiconductor integrated circuit 31 is also included. Further, in this embodiment, the voltage, the temperature, and the ESD are monitored as an example. However, atmospheric pressure and humidity may also be included, and internal monitors of the semiconductor integrated circuit 31 may also be used.

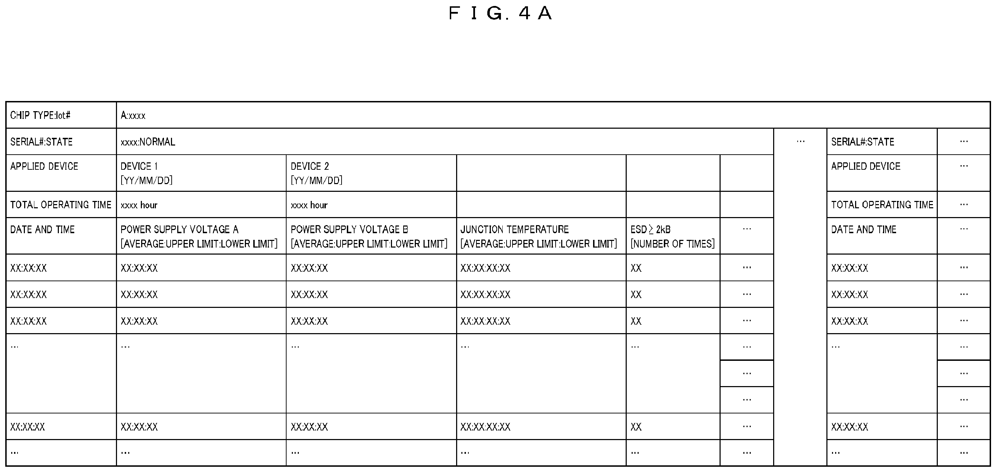

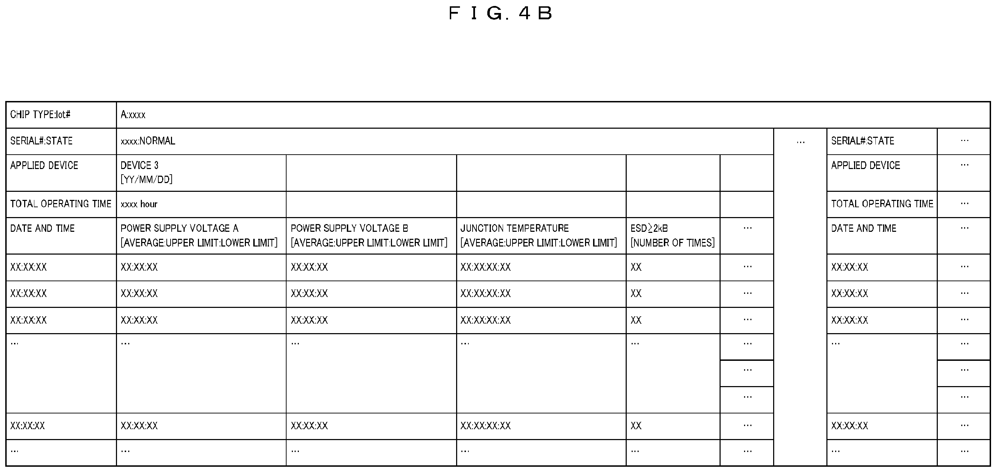

Figs. 4A and 4B show examples of the monitoring data 16.

The monitoring data 16 stores a serial number, an operating state, a previously applied device, a total operating time, and monitored data for each semiconductor integrated circuit 31. For the monitored power supply voltage, temperature, and ESD data, the average values, upper limit values, and lower limit values thereof are recorded daily or at other specific intervals.

The total operating time is information indicating the cumulative operating time of the semiconductor integrated circuit 31. For example, the cumulative time during which the power supply voltage is supplied to the semiconductor integrated circuit 31 is the operating time. The cumulative time is monitored by the CPU 306 or the like.

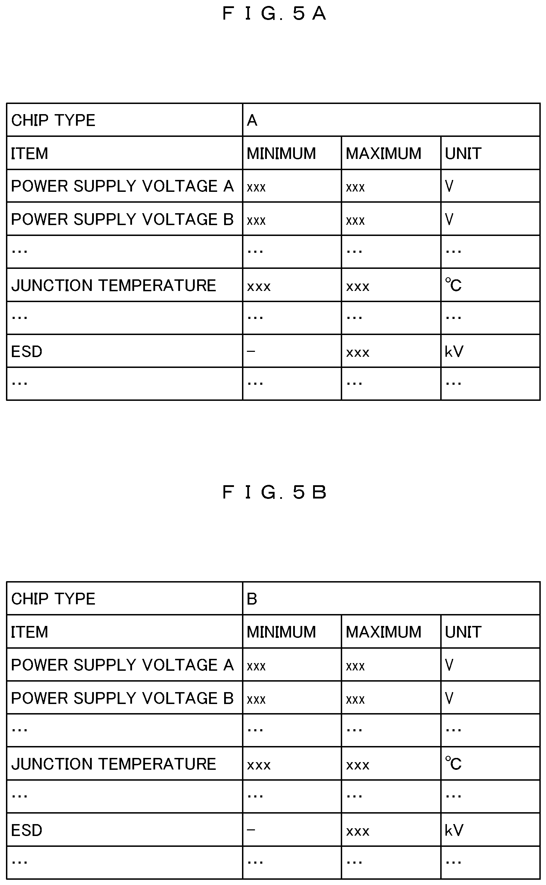

Figs. 5A and 5B show examples of the rated data 17.

The rated values are extracted from, for example, the data sheet of the semiconductor integrated circuit 31 to be subjected to the reuse determination and are then input.

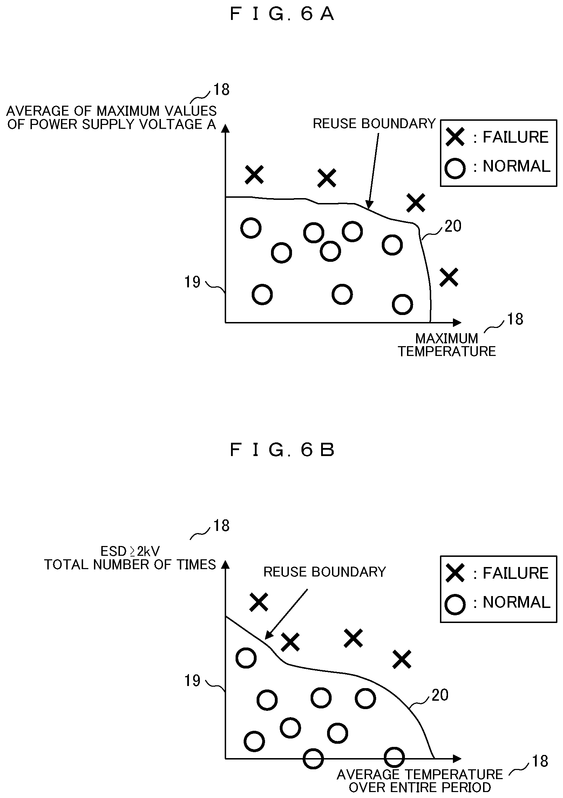

Figs. 6A and 6B show examples of the classification data 19 and the reuse boundary data 20. The statistical values of the monitoring data 16 (here, the average of the maximum values of the power supply voltage, the maximum temperature, the total number of ESD events, and the average temperature over the entire period) are calculated based on the monitoring statistics calculation data 18. The state of each semiconductor integrated circuit 31 is plotted on the axes, and the number of plotted data items is collected to calculate the plane (a curve due to a two-dimensional graph in Figs. 6A and 6B) that separates the normal data group from the failure data group.

This plane is the reuse boundary, and reusability can be determined based on whether or not the data is present within a normal data group region at the next monitoring timing. Even in the normal state, when the data is plotted within a failure data group region, it indicates a high probability of failure in a short period of time. Therefore, it is determined that the circuit cannot be reused.

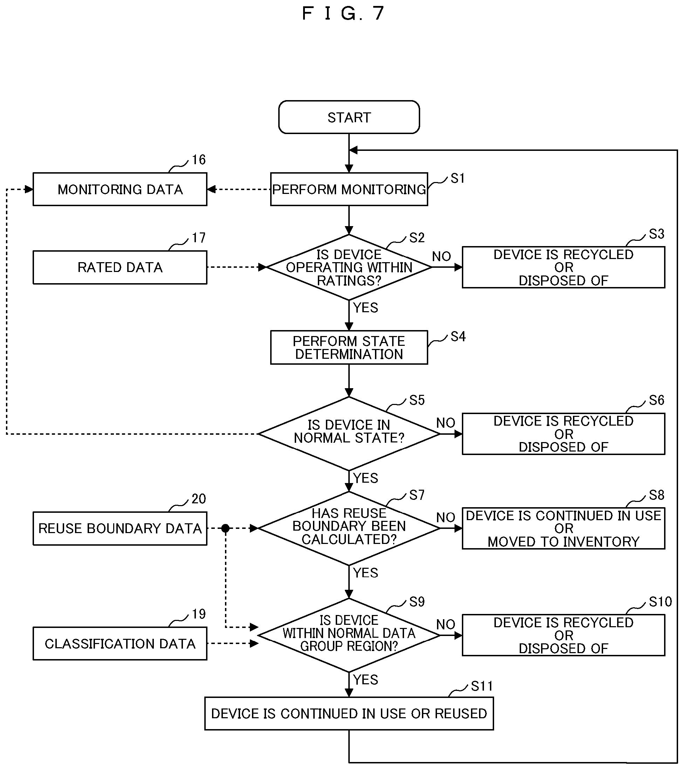

Next, a process performed by the computer 1 will be described. Fig. 7 is a flowchart showing an example of the process performed by the computer 1 when the reusability of each of the semiconductor integrated circuits 31 is determined. Here, dotted lines in Fig. 7 indicate the locations where data is input and output.

First, the processor 10 performs the monitoring of each electronic device 3 at any time (Step S1). The monitoring timing may be the timing at which the semiconductor integrated circuit 31 has failed. As a result, data is accumulated in the monitoring data 16.

Then, the processor 10 compares the acquired monitoring data 16 with the rated data 17 and determines whether or not the device operates outside the ratings (Step S2). When the circuit operates outside the ratings (NO), there is a possibility that the degradation of the semiconductor integrated circuit 31 may be accelerating even though the semiconductor integrated circuit 31 operates normally. Therefore, in Step S3, the semiconductor integrated circuit 31 will be recycled or disposed of. When the device operates within the ratings (YES), the process proceeds to Step S4 to perform state determination.

Then, the state determination is performed (Step S5). When it is determined that the circuit has failed (NO), the process proceeds to Step S6 to proceed with recycling or disposal. When it is determined that the device is normal (YES), the process proceeds to Step S7. At this time, information regarding normality or failure is stored as the operating state in the monitoring data 16.

In Step S7, it is determined whether the reuse boundary has been calculated. In addition, a calculation flow of the reuse boundary will be described with reference to a separate flowchart. When the reuse boundary has not been calculated (NO), the process proceeds to Step S8, and the corresponding semiconductor integrated circuit 31 is continued in use or secured as inventory. The term "continued in use" here assumes that the electronic device 3 is continued in use at the monitoring timing.

When reusability is determined, in a situation in which the reuse boundary has not been calculated, it is not possible to determine reusability. Therefore, it is also considered to move the device to inventory. When the reuse boundary has been calculated (YES), the process proceeds to Step S9.

In Step S9, the state of the corresponding semiconductor integrated circuit 31 is mapped onto the graph of the classification data 19, and it is determined whether the semiconductor integrated circuit is within the normal data group region. When the semiconductor integrated circuit is outside the normal data group region, the process proceeds to recycling or disposal (Step S10). When the semiconductor integrated circuit is within the normal data group region, it is determined that the semiconductor integrated circuit can be continued in use or reused (Step S11).

It has been described above that the reusability of each semiconductor integrated circuit 31 can be easily determined based on the reuse boundary data 20. Next, a method of generating the reuse boundary data will be described.

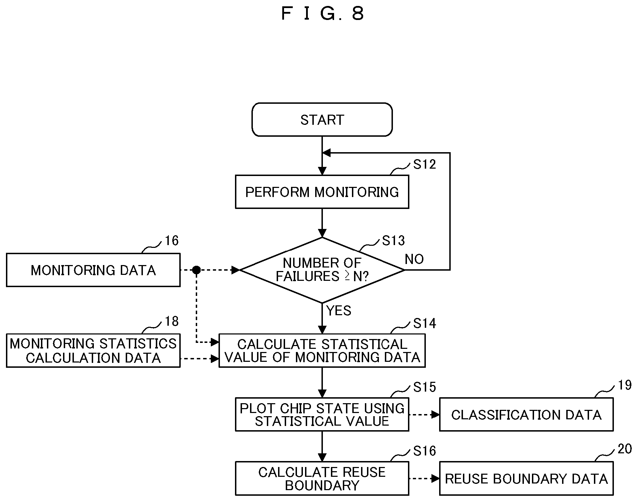

Fig. 8 shows an example of a method of generating the reuse boundary data 20. Here, dotted lines in Fig. 8 indicate the locations where data is input and output.

First, the processor 10 performs monitoring (Step S12).

Then, it is determined whether a predetermined number of (here, N) failures have been accumulated with reference to the monitoring data 16 (Step S13). When the number of failures is less than N (NO), the process returns to Step S12. When the number of failures is equal to or greater than N (YES), the process proceeds to Step S14. The reason for collecting a predetermined number of failures here is that there is a high probability of the absolute value of the number of failures being small in the operation of the electronic device 3 and a sufficient amount of data is required to calculate the reuse boundary.

Then, in Step S14, the statistical values of the monitoring data 16 are calculated based on the monitoring data 16 and the monitoring statistics calculation data 18. Here, the statistical values are, for example, the maximum power supply voltage over the total operating time and the like, and the state of each semiconductor integrated circuit 31 can be mapped onto the graph by calculating unique values as the statistical values (Step S15). This graph having the state mapped thereon becomes the classification data 19.

Then, a reuse boundary plane for separating the normal group from the failure group is calculated from the classification data 19 (Step S16). The plane can be calculated using machine learning. For example, an algorithm, such as Support Vector Machine (SVM), is used. The calculated reuse boundary plane is stored as the reuse boundary data 20. The process of calculating the reuse boundary by the processor 10 has been described above. This concludes the basic process performed by the computer 1.

According to Embodiment 1, the calculation of the reuse boundary makes it possible to instantly determine whether each semiconductor integrated circuit 31 can be continued in use or reused at any monitoring timing.

### [Embodiment 2]

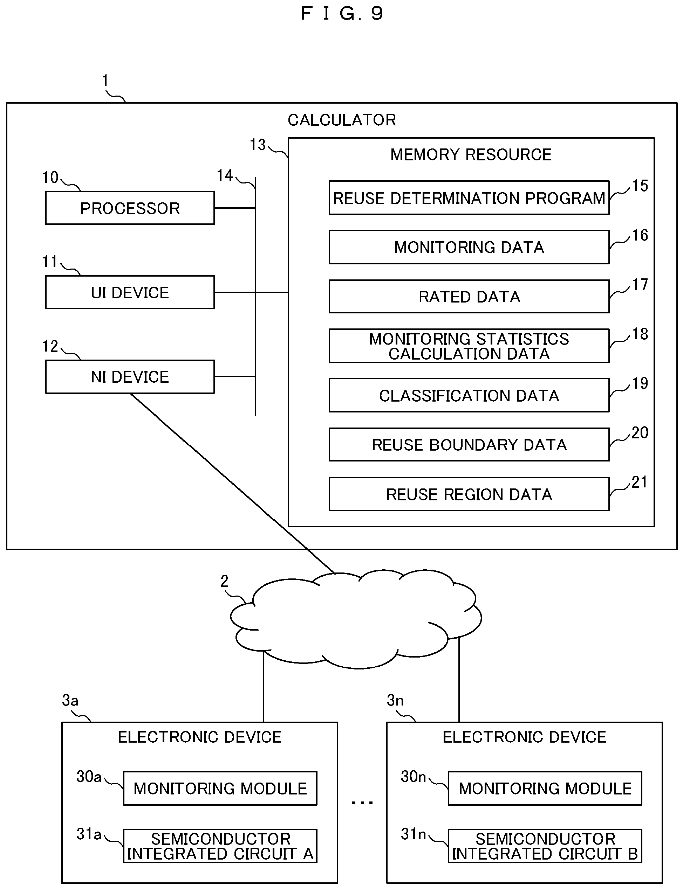

Fig 9 is a diagram showing an example of a configuration of a computer 1 according to Embodiment 2.

In Embodiment 2, the content of the reuse determination program 15 in the memory resource 13 differs from that in Embodiment 1, and reuse region data 21 is added. Since the other configurations are the same as those in the example of the configuration of the computer 1 according to Embodiment 1 (see Fig. 2), a detailed description thereof will be omitted.

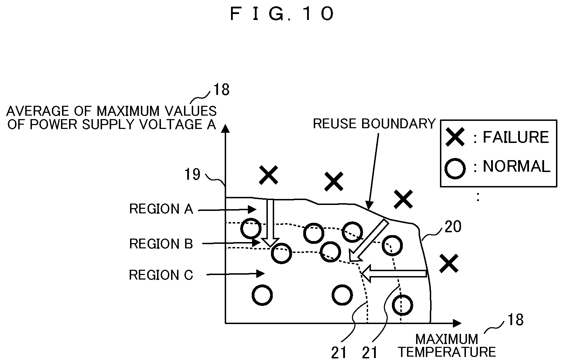

Fig. 10 shows an example of the reuse region data 21.

The reuse region data 21 is information in which regions are divided according to the distance from the reuse boundary. When the monitored voltage and temperature are regarded as stress on the semiconductor integrated circuit 31, it can be said that the closer the data is to the reuse boundary, the greater the stress is. Therefore, the division of the regions makes it possible to divide reliability based on the accumulated amount of stress on the target semiconductor integrated circuit 31. It is possible to select a reuse destination depending on which region the circuit belongs to during the reuse determination.

For example, a region A in Fig. 10 is close to the reuse boundary. Therefore, even when the circuit operates normally, the accumulated stress is large, and there is a possibility that degradation may be accelerated. As a result, the reliability during reuse is reduced.

Meanwhile, a region C is furthest from the reuse boundary, and it can be said that the reliability is high. For example, a prototype product is considered as the reuse destination of a device with low reliability. On the other hand, a device with high reliability is considered to be reused for products.

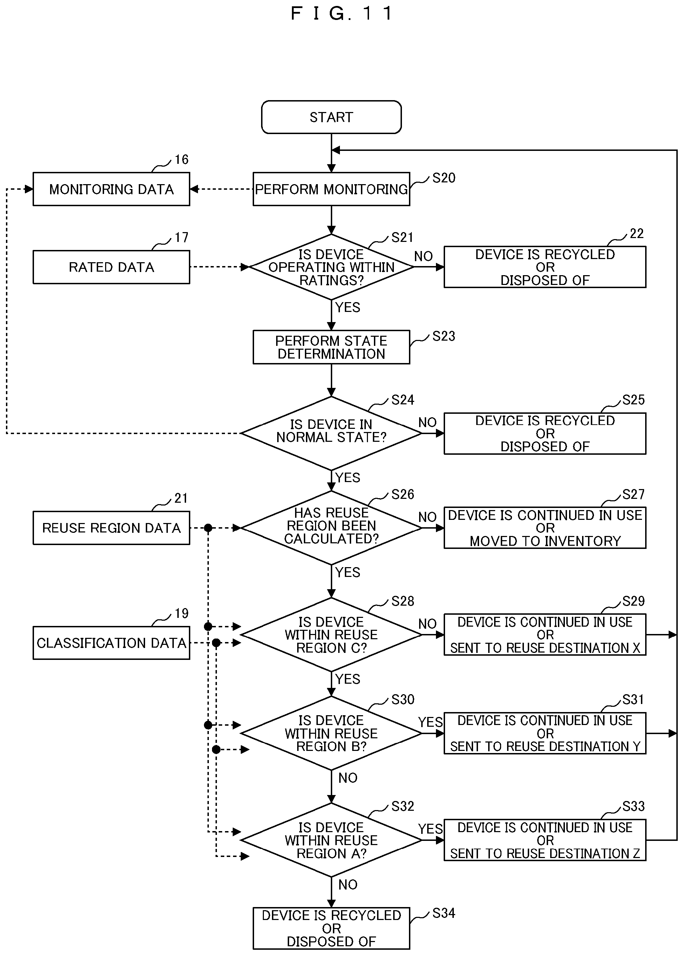

Fig. 11 is a flowchart showing an example of a process performed by the computer 1 when the reusability of each semiconductor integrated circuit 32 is determined in another embodiment. Here, dotted lines in Fig. 11 indicate the locations where data is input and output.

Since Steps S20 to S25 are the same processes as Steps S1 to S6 in Fig. 7 in Embodiment 1, a description thereof will be omitted.

In Step S26, it is determined whether the reuse region data 21 has been calculated. When the reuse region data 21 has not been calculated, the circuit is continued in use or moved to inventory (Step S27). When the reuse region data 21 has been calculated, the process proceeds to Step S28.

In Step S28, it is determined whether the circuit is plotted within the reuse region C. When the circuit is within the reuse region C, it is continued in use or sent to a reuse destination X which requires high reliability (Step S29). When the circuit is within a region other than the reuse region C, the process proceeds to Step S30.

In Step S30, it is determined whether the circuit is plotted in the reuse region B. When the circuit is within the reuse region B, it is continued in used or sent to a reuse destination Y which requires medium reliability (Step S29). When the circuit is within a region other than the reuse region B, the process proceeds to Step S32.

In Step S32, it is determined whether the circuit is plotted in the reuse region A. When the circuit is within the reuse region A, it is continued in used or sent to a reuse destination Z which requires low reliability (Step S29). When the circuit is within a region other than the reuse region A, the process proceeds to Step S34. When the circuit does not belong to any region (Step S34), it belongs to the failure data group region. Therefore, the circuit is recycled or disposed of.

Here, an automobile (ECU) or the like is given as an example of the reuse destination X. In addition, an inspection device (signal processing system) is given as an example of the reuse destination Y. A prototype for the inspection device is given as an example of the reuse destination Z. Here, the example in which there are three regions has been described. However, the number of regions may be equal to or greater than or equal to or less than three.

It has been described above that it is possible to easily determine the reusability and reuse destination of each semiconductor integrated circuit 31, using the reuse region data 21. Next, a method of generating the reuse region data 21 will be described.

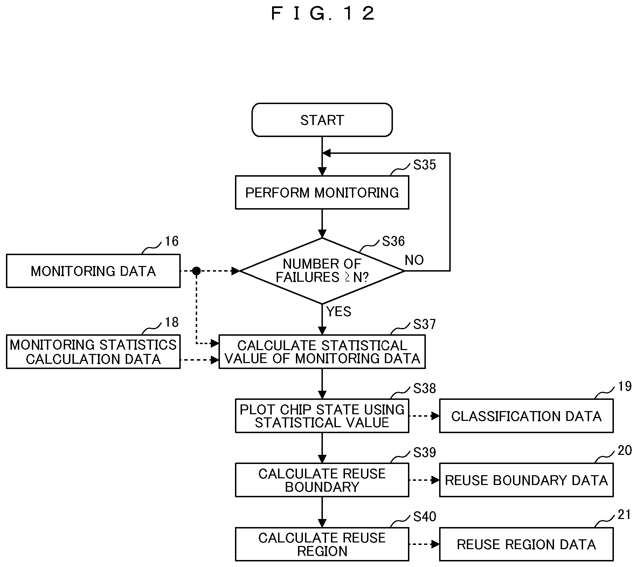

Fig. 12 shows an example of the method of generating the reuse region data 21. Here, dotted lines in Fig. 12 indicate the locations where data is input and output.

Since Steps S35 to S39 are the same processes as Steps S12 to S16 in Fig. 8 in Embodiment 1, a description thereof will be omitted.

In Step S40, the reuse region is calculated from the calculated reuse boundary. The reuse region is defined, for example, as a proportionally scaled-down region when the area from a reuse boundary line to the minimum value of each axis is considered as shown in Fig. 10. For example, as shown in Fig. 10, a region obtained by reducing a figure formed by the reuse boundary and the axes of the graph toward the direction of a region C21 from the reuse boundary 20 (the direction of an arrow in Fig. 10) while maintaining a similarity relationship is calculated as the reuse region. This concludes the basic process performed by the computer 1.

According to Embodiment 2, the calculation of the reuse region makes it possible to instantly determine whether each semiconductor integrated circuit 31 can be continued in use or reused and the reuse destination of each semiconductor integrated circuit 31, at any monitoring timing.

The present invention is not limited to the above-described embodiments and includes various modifications. For example, the above-described embodiments have been explained in detail to facilitate a clear understanding of the present invention, and the present invention is not necessarily limited to the configurations including all the above-described components.

Furthermore, a part of the configuration of one embodiment can be replaced with the configuration of another embodiment, and the configuration of one embodiment can be added to the configuration of another embodiment. In addition, for some of the configurations of each embodiment, other configurations can be added, deleted, or replaced.

Further, some or all of the above-described configurations, functions, processing units, processing means, and the like may be implemented by hardware, for example, by designing them as an integrated circuit. In addition, the above-described configurations, functions, and the like may be implemented by software. For example, a processor interprets a program for implementing each function and executes the program to implement the above-described configurations, functions, and the like.

Information, such as programs, determination tables, and files, for implementing each function can be stored in storage devices, such as a memory, an HDD, and an SSD, or in recording media, such as an integrated circuit (IC) card, a secure digital (SD) card, and a digital versatile disc (DVD). Furthermore, control lines and information lines indicate what is deemed necessary for the description, and not all control lines and information lines are necessarily shown from the perspective of a product. In practice, it may be considered that almost all of the configurations are interconnected.

The user (operator) may perform some or all of the functions and processes implemented by the reuse determination program 15 to implement the computer 1.

In addition, in some cases, the computer 1 does not have the UI device 11, and a part of an output process to the user and an input process from the user is entrusted to a processor system (referred to as an external processor system), such as a smartphone or a tablet terminal, outside the system. In this case, the computer 1 (or the processor 10 or the reuse determination program 15) may execute other parts of the above-described processes and programs to perform the following.

Instead of the output to the user using the UI device 11, data necessary for the output to the user is transmitted to an external processor system via the NI device 12.

As examples of the data, the output data and data for generating the output data in another processor system are considered. The data may be a program or Web data in which a process of performing user output in the external processor system has been described.

Instead of the reception of input or operations from the user using the UI device 11, data indicating user input or operations is received from the external processor system via the NI device 12. From another perspective, the meaning of the output of data to the user may include not only the output of data by the computer 1 but also causing (serving) another entity other than the computer 1 to output the data.

In addition, the meaning of the reception of input or operations from the user may include not only direct output to or reception from the user via the UI device 11 of the computer 1 but also indirect reception by the computer 1.

According to the above-described embodiments, it is possible to easily predict the remaining life of an electronic component. For example, it is possible to easily predict the reusability of a semiconductor integrated circuit.

### REFERENCE SIGNS LIST

- 1: Computer
- 2: Network
- 3: Electronic device
- 10: Processor
- 11: UI device
- 12: NI device
- 13: Memory resource
- 14: Bus
- 15: Reuse determination program (reuse determination unit)
- 16: Monitoring data
- 17: Rated data
- 18: Monitoring statistics calculation data
- 19: Classification data
- 20: Reuse boundary data
- 21: Reuse region data
- 30: Monitoring module
- 31: Semiconductor integrated circuit
- 300: Power supply voltage sensor
- 301: Temperature sensor
- 302: ESD sensor
- 303: Failure detection circuit
- 304: Non-volatile memory
- 305: AD converter
- 306: CPU
- 307: Data transmission circuit

## Claims

1. A reuse determination device for a semiconductor integrated circuit, comprising:
a reuse determination unit determining reusability of the semiconductor integrated circuit,
wherein a processor causes the reuse determination unit to
determine a state of the semiconductor integrated circuit using monitoring data of the semiconductor integrated circuit,
recycle or dispose of the semiconductor integrated circuit when the state of the semiconductor integrated circuit is determined to be a failure,
calculate a statistical value of the monitoring data and acquire monitoring statistics calculation data when the state of the semiconductor integrated circuit is determined to be normal,
map the normal state and the failure state of the semiconductor integrated circuit onto a graph, using the monitoring statistics calculation data,
calculate a reuse boundary for separating a region on the graph into a normal data group region indicating the normal state and a failure data group region indicating the failure state, and
determine the reusability of the semiconductor integrated circuit based on the reuse boundary.

2. The reuse determination device according to Claim 1,
wherein the processor causes the reuse determination unit to
determine whether the monitoring statistics calculation data is present in the normal data group region or in the failure data group region,
recycle or dispose of the semiconductor integrated circuit when it is determined that the monitor statistics calculation data is present in the failure data group region, and
continue to use or reuse the semiconductor integrated circuit when it is determined that the monitor statistics calculation data is present in the normal data group region.

3. The reuse determination device according to Claim 1,
wherein the processor causes the reuse determination unit to calculate the reuse boundary for separating the region on the graph into the normal data group region and the failure data group region using machine learning.

4. The reuse determination device according to Claim 1,
wherein the processor causes the reuse determination unit to
divide the normal data group region into a plurality of reuse regions, and
determine a reuse destination of the semiconductor integrated circuit according to the divided reuse regions.

5. The reuse determination device according to Claim 4,
wherein the processor causes the reuse determination unit to
divide the normal data group region into a plurality of the reuse regions corresponding to reliability calculated from an amount of stress related to the semiconductor integrated circuit, and
determine the reuse destination of the semiconductor integrated circuit based on the reliability.

6. The reuse determination device according to Claim 4,
wherein the processor causes the reuse determination unit to calculate, as the reuse region, a region obtained by reducing a figure formed by the reuse boundary and axes of the graph while maintaining a similarity relationship.

7. The reuse determination device according to Claim 1,
wherein the processor causes the reuse determination unit to
determine whether the semiconductor integrated circuit exceeds a rated value, using the monitoring data, and
recycle or dispose of the semiconductor integrated circuit when it is determined that the semiconductor integrated circuit exceeds the rated value.

8. The reuse determination device according to Claim 1,
wherein the processor causes the reuse determination unit to calculate, as the statistical value of the monitoring data, a maximum value, a minimum value, or a standard deviation of the monitoring data during a predetermined period.

9. A reuse determination system for a semiconductor integrated circuit, comprising:
a reuse determination device including a reuse determination unit determining reusability of a semiconductor integrated circuit; and
a plurality of electronic devices,
wherein the reuse determination device and the plurality of electronic devices are connected via a communication line,
each of the electronic devices includes the semiconductor integrated circuit and a monitoring module acquiring monitoring data of the semiconductor integrated circuit,
the reuse determination device acquires the monitoring data from the monitoring module of the electronic device via the communication line, and
a processor causes the reuse determination unit to
determine a state of the semiconductor integrated circuit using the monitoring data,
recycle or dispose of the semiconductor integrated circuit when the state of the semiconductor integrated circuit is determined to be a failure,
calculate a statistical value of the monitoring data and acquire monitoring statistics calculation data when the state of the semiconductor integrated circuit is determined to be normal,
map the normal state and the failure state of the semiconductor integrated circuit onto a graph, using the monitoring statistics calculation data,
calculate a reuse boundary for separating a region on the graph into a normal data group region indicating the normal state and a failure data group region indicating the failure state, and
determine the reusability of the semiconductor integrated circuit based on the reuse boundary.

10. The reuse determination system according to Claim 9,
wherein each of the electronic devices includes the monitoring module common to each of the semiconductor integrated circuits, and
the monitoring module includes
a power supply voltage sensor, a temperature sensor, and an ESD sensor for monitoring a power supply voltage, a temperature, and an ESD which are rated values of the semiconductor integrated circuit, respectively, and
a failure detection circuit detecting a failure in the semiconductor integrated circuit.

11. The reuse determination system according to Claim 9,
wherein the processor causes the reuse determination unit to
determine whether the monitoring statistics calculation data is present in the normal data group region or in the failure data group region,
recycle or dispose of the semiconductor integrated circuit when it is determined that the monitor statistics calculation data is present in the failure data group region, and
continue to use or reuse the semiconductor integrated circuit when it is determined that the monitor statistics calculation data is present in the normal data group region.

12. The reuse determination system according to Claim 9,
wherein the processor causes the reuse determination unit to
divide the normal data group region into a plurality of reuse regions, and
determine a reuse destination of the semiconductor integrated circuit according to the divided reuse regions.

13. The reuse determination system according to Claim 12,
wherein the processor causes the reuse determination unit to
divide the normal data group region into a plurality of the reuse regions corresponding to reliability calculated from an amount of stress related to the semiconductor integrated circuit, and
determine the reuse destination of the semiconductor integrated circuit based on the reliability.

14. The reuse determination system according to Claim 10,
wherein the processor causes the reuse determination unit to
determine whether the semiconductor integrated circuit exceeds a rated value, using the monitoring data, and
recycle or dispose of the semiconductor integrated circuit when it is determined that the semiconductor integrated circuit exceeds the rated value.

15. A reuse determination method for a semiconductor integrated circuit that determines reusability of the semiconductor integrated circuit using a processor, the reuse determination method comprising:
a step of determining a state of the semiconductor integrated circuit using monitoring data of the semiconductor integrated circuit;
a step of recycling or disposing of the semiconductor integrated circuit when the state of the semiconductor integrated circuit is determined to be a failure;
a step of calculating a statistical value of the monitoring data and acquiring monitoring statistics calculation data when the state of the semiconductor integrated circuit is determined to be normal;
a step of mapping the normal state and the failure state of the semiconductor integrated circuit onto a graph, using the monitoring statistics calculation data;
a step of calculating a reuse boundary for separating a region on the graph into a normal data group region indicating the normal state and a failure data group region indicating the failure state; and
a step of determining the reusability of the semiconductor integrated circuit based on the reuse boundary.
